# EUROPEAN PATENT APPLICATION

(11) **EP 4 575 519 A1**
(43) Date of publication of application: **25.06.2025**
(21) Application number: 23217751.9
(22) Date of filing: 18.12.2023
(51) Int. Cl.: G01R 1/20

(54) **APPARATUS FOR DETERMINING AN ELECTRICAL PARAMETER OF A BUS BAR**

(71) Applicant: Volvo Car Corporation, 405 31 Göteborg (SE)
(72) Inventor: ANDERSSON, Kenneth, 40531 Göteborg (SE); TEMPALLE, Swetcha, 40531 Göteborg (SE)
(74) Representative: Maiwald GmbH

(57) **Abstract**

The disclosure relates to an apparatus (10) for determining an electrical parameter of a bus bar (50), the apparatus (10) comprising: a first measuring system (20) for attachment to the bus bar (50), the first measuring system (20) being configured to provide a first signal indicative of a temperature of the bus bar (50); a second measuring system (30) for attachment to the bus bar (50), the second measuring system (30) being configured to provide a second signal indicative of a voltage of the bus bar (50); and an interface system (40) configured to provide the first and the second signals to a determination unit (44) for determining the electrical parameter of the bus bar (50) based on the first signal and the second signal.

## Description

### TECHNICAL FIELD

The present disclosure relates to an apparatus for determining an electrical parameter of a bus bar, a bus bar system for use in a vehicle, and a method for determining an electrical parameter of a bus bar.

### BACKGROUND ART

Measuring apparatuses for determining an electrical current, an electrical resistance, or an electrical voltage of a bus bar are known to use two types of measurements to determine these electric parameters. These two types of measurements may be electrical voltage measurements using a shunt resistor that comprises a defined electrical resistance, and a temperature measurement using a temperature measuring means.

It is known that such measuring apparatuses are not very robust and that the measurements are not sufficiently precise for various applications or would be desirable.

### SUMMARY

The above problems are at least partially solved or alleviated by the subject matter of the independent claims of the present disclosure, whereby further examples are incorporated in the dependent claims.

According to a first aspect of this disclosure, there is provided an apparatus for determining an electrical parameter of a bus bar, the apparatus comprising: a first measuring system for attachment to the bus bar, the first measuring system being configured to provide a first signal indicative of a temperature of the bus bar; a second measuring system for attachment to the bus bar, the second measuring system being configured to provide a second signal indicative of a voltage of the bus bar; and an interface system configured to provide the first and the second signals to a determination unit for determining the electrical parameter of the bus bar based on the first signal and the second signal.

By having the first measuring system and the second measuring system attached to the bus bar, precise measurements with little or no deviation in the measurements may be made. The results of the measurements may be represented by or included in the first signal and the second signal. By providing these to the determination unit, a particularly precise and robust determination of the electrical parameter of the bus bar can be made.

In particular, the first measuring system may be configured for attachment to the bus bar. For example, the first measuring system may comprise a surface configured, e.g., by choice of its material, for welding and/or soldering it to the bus bar. The surface may be present on a layer element of the first measuring system as explained below, for example. Also, the second measuring system may be configured for attachment to the bus bar. For example, the second measuring system may comprise a surface configured, e.g., by choice of its material, for welding and/or soldering it to the bus bar. Alternatively, or additionally, the second measuring system may comprise a fastening means, e.g., a threaded hole or bolt or screw, for attachment to the bus bar. The surface or fastening means may be provided on one or more mounting units of the second measuring system, for example. The attachment of the first and second measuring system to the bus bar provides for direct and precise measurements of the temperature and the voltage of the bus bar aiding in the robustness and precision of the apparatus.

The electrical parameter of the bus bar may be determined when the bus bar is supplied with electrical energy. The electrical energy may be provided by the combination of current, represented as electrical current in a unit of ampere, and electrical potential, represented as electrical voltage in a unit of volt, provided by the electrical energy generator, electrical energy storage device, or any other of the previously mentioned examples for providing the electrical energy. The electrical parameter may relate to the supplied electrical energy. For example, the electrical parameter may be at least one of an electrical voltage, an electrical current, and an electrical resistance of the bus bar.

The bus bar may be configured to provide electrical energy from an electrical energy source, such as at least one of electrical energy generator, and an electrical energy storage device, to an electrical energy consumer, such as at least one of an electrical motor, and a control device, for operation thereof. The bus bar may comprise at least one of a strip, a wire, and a rail. The bus bar may be configured to transmit a current of the electrical energy, and provide an electrical potential of the electrical energy.

The determination unit may be configured as a computer, processor and/or microcontroller, for example. The interface system may be configured for connection or, in other words, connectable to the determination unit. For example, the interface system may comprise a corresponding connector or other unit for establishing this connection. The first signal and second signal may be provided to the determination unit via such connection.

The first signal and the second signal may be electrical signals and/or data signals, for example. For example, the first signal and the second signal may be indicative of the temperature or voltage of the bus bar based on a voltage, in particular voltage amplitude, of their signal. Additionally, or alternatively, for example, the first signal and the second signal may contain data or information, for example in the form of computer readable code or text, indicative of the temperature or voltage of the bus bar.

In an example, the second measuring system may comprise electrically conductive mounting units. Further, the second measuring system may comprise an electrically conductive carrier unit for carrying at least part of the interface system. The carrier unit may be mountable to the bus bar via the mounting units to electrically connect the interface system to the bus bar. The carrier unit may in particular be configured for carrying at least part of the interface system, e.g., at least one component thereof, such as the amplifier as mentioned below and/or the determination unit. For example, the carrier unit may have a connection interface for connecting the amplifier and/or the determination unit thereto. The mounting units may be made from metal and/or have a cylindrical shape, for example. The mounting units may be designed as pins, for example. The second signal may accordingly be provided, e.g., as a voltage, via the mounting units and the carrier unit to the interface system. The mounting units may for example be configured to connect the measuring system to at least one of the strips, the wires, and the rails of the bus bar. Alternatively, or additionally, the mounting units may be configured to connect the measuring system to a first potential of the bus bar, and to a second potential of the bus bar, wherein a potential difference may exist between the first potential and the second potential.

In an example, the carrier unit may be a printed circuit board (PCB). The PCB may have tracks for transferring the second signal from the mounting units to the interface system, which further provides the first and second signal to the determination unit.

In an example, the first measuring system may comprise a layer unit for attachment to the bus bar. The layer unit may comprise at least two layer elements, at least one of a top layer element and a bottom layer element of the layer elements being electrically conductive. The first measuring system may further comprise a measuring unit thermally connectable to the layer unit for measuring the temperature of the bus bar via the layer elements. The measuring unit may further be configured to generate the first signal. For example, the measuring unit may comprise a temperature sensor and/or integrated circuit. The at least two electrically conductive layer elements may transmit the temperature of the bus bar to the measuring unit. Accordingly, by having the electrically conductive layer elements, the layer unit may thermally conduct the temperature of the bus bar to the measuring unit for measuring the temperature of the bus bar and generating the first signal.

In an example, at least one of the top layer element and the bottom layer element may comprise at least one of copper and aluminum. Thereby, the top layer element and/or the bottom layer element may provide a particularly good electrical and thermal conductivity for a high precision in the temperature measurement.

In an example, the layer unit may comprise three or more layer elements. For example, the layer unit may comprise four, five or more layer elements. Other layer elements than the top and/or bottom layer element may have other properties than being electrically conductive, e.g., being galvanically and/or electrically isolating.

In an example, at least one intermediate layer element of the layer elements may be arranged between the top layer element and the bottom layer element may be galvanically isolating. Thereby, the layer unit may be configured to isolate the electrical energy of the bus bar from the measuring unit. Thereby, the layer unit may protect the measuring unit against the electrical energy carried by the bus bar but still transfer the temperature of the bus bar directly to the measuring unit so that particularly accurate temperature measurements are provided.

In an example, the at least one intermediate layer element may comprise a dielectric material. This provides for the galvanically isolating properties and prevention of transfer of electrical energy, while allowing thermal transfer through the layer unit. The dielectric material may be, for example, a resin material.

In an example, the interface system may comprise an amplifier configured to amplify the second signal. The amplifier may be configured for signal conditioning. For example, the amplifier may be a differential amplifier or an isolated amplifier. It may be used as a DC voltage amplifier, for example. Thereby, the second signal may be reliably received at the determination unit and the processing of the second signal for the determination of the electrical parameter may be improved.

In an example, the apparatus may comprise the determination unit. The determination unit may comprise data indicative of a correlation of a temperature of the bus bar to an electrical resistance of the bus bar. The determination unit may be configured to determine an electrical resistance of the bus bar based on the first signal and the data. Further, the determination unit may be configured to determine the electrical parameter of the bus bar based on the second signal and the determined electrical resistance of the bus bar. Accordingly, the electrical parameter, e.g., voltage, of the bus bar may be determined in dependence of an electrical resistance of the bus bar that may be influenced by the temperature. Determining the electrical resistance, a calibration of the determination unit for determining the electrical parameter may be provided. The correlation of the temperature of the bus bar to the electrical resistance may be known from experiment, a formula, a model or similar, for example. Accordingly, the data may comprise or be based on one or more look up tables, one or more formulas, and/or one or more models. Thereby, the precision of the electrical parameter determination by the apparatus may be increased.

According to a second aspect of this disclosure, there is provided a bus bar system for use in a vehicle, the bus bar system comprising a bus bar and the apparatus according to the first aspect of this disclosure, the first measuring system being attached to the bus bar and the interface system being electrically connected to the bus bar via the second measuring system. Accordingly, the second measuring system may be attached to the bus bar.

In an example, at least one of the first measuring system and the second measuring system may be attached to a first portion of the bus bar, the first portion having a smaller cross section than a second portion of the bus bar. The second portion or two second portions may be remainders of the bus bar. The first portion may be located in between two second portions. It has been found that the measurement precision and the robustness of the apparatus may be increased when providing the bus bar with such a smaller cross section portion and providing the apparatus at the smaller cross section portion. For example, at least one of the measurements may be performed perpendicular to an extension direction of the bus bar.

In an example, the attachment of at least one of the first measuring system and the second measuring system to the bus bar may comprise a welding connection or soldering connection. Thereby, the electrical and thermal conductivity are increased, resulting in a better measurement precision of the apparatus.

According to a third aspect of this disclosure, there is provided a method for determining an electrical parameter of a bus bar by an apparatus according to the first aspect of this disclosure or in a bus bar system according to the second aspect of this disclosure, the method comprising:
- receiving the first signal;
- receiving the second signal; and
- determining the electrical parameter of the bus bar based on the first signal and the second signal.

The method may be at least partially computer-implemented. Accordingly, one, multiple or all steps of the method may be carried out by a computer, in particular the determination unit of the apparatus. The method may be implemented in software, or in hardware, or in software, and hardware. Further, the method may be carried out by computer program instructions running on means that provide data processing functions. The data processing means may be a suitable computing means, such as an electronic control module etc., which may also be a distributed computer system. The data processing means, or the computer, respectively, may comprise one, or more of a processor, a memory, a data interface, or the like.

In an example, the determining of the electrical parameter may comprise determining an electrical resistance of the bus bar based on the first signal and data indicative of a correlation of a temperature of the bus bar to an electrical resistance of the bus bar, and determining the electrical parameter of the bus bar based on the second signal and the determined electrical resistance of the bus bar.

It is noted that the above examples may be combined with each other irrespective of the aspect involved. Accordingly, the method may be combined with structural features and, likewise, the apparatus may be combined with features described above with regard to the method.

These, and other aspects of the present disclosure will become apparent from and elucidated with reference to the examples described hereinafter.

### BRIEF DESCRIPTION OF DRAWINGS

Examples of the disclosure will be described in the following with reference to the following drawings.
- Figure 1: shows a schematic illustration of a bus bar system in a vehicle;
- Figure 2: shows an exemplary illustration of the bus bar system of Fig. 1;
- Figure 3: shows an exemplary illustration of a layer unit of a first measuring system of the bus bar system of Figs. 1 and 2; and
- Figure 4: shows a schematic illustration of a method for determining an electrical parameter of a bus bar by an apparatus of the bus bar system of Figs. 1, 2 and 3.

### DETAILED DESCRIPTION

Notably, the figures are merely schematic representations, and serve only to illustrate examples of the present disclosure. Identical, or equivalent elements are in principle provided with the same reference signs.

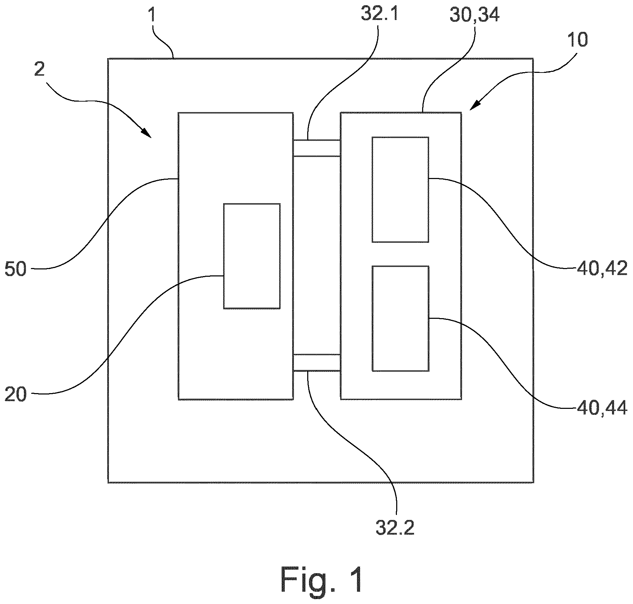

Figure 1 shows a schematic illustration of an apparatus 10 mounted to a bus bar 50 in a vehicle 1. The apparatus 10 and the bus bar 50 form a bus bar system 2. The bus bar 50 may serve the purpose of transferring electrical energy within the vehicle 1, e.g., from an electrical energy source to an electrical energy consumer. The apparatus 10 may serve the purpose of determining an electrical parameter, e.g., current, of the electrical energy transferred by the bus bar 50, e.g., in the range of 0 to 1000s of amps, and with bidirectional current determination.

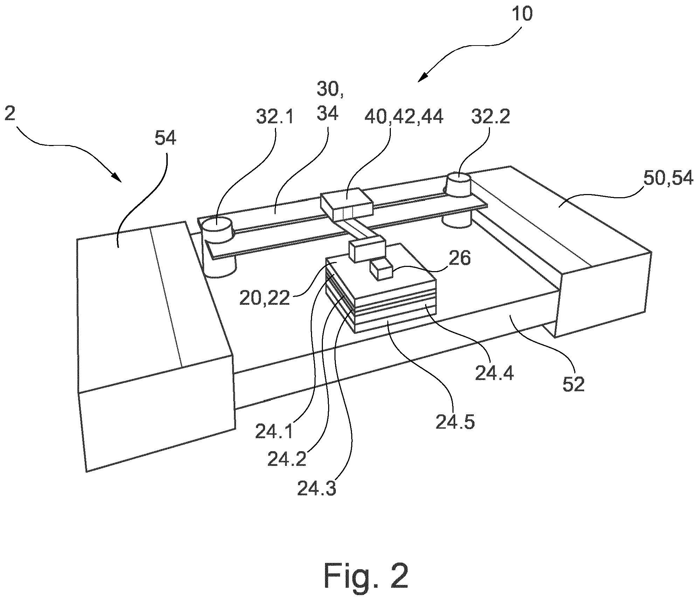

As may be further seen from Fig. 1 and from Fig. 2, the apparatus 10 comprises a first measuring system 20 for measuring the temperature of the bus bar 50 (shown only partially herein) and a second measuring system 40 for measuring a voltage of the bus bar 50 or, in other words, the electrical energy transferred or carried by the bus bar 50.

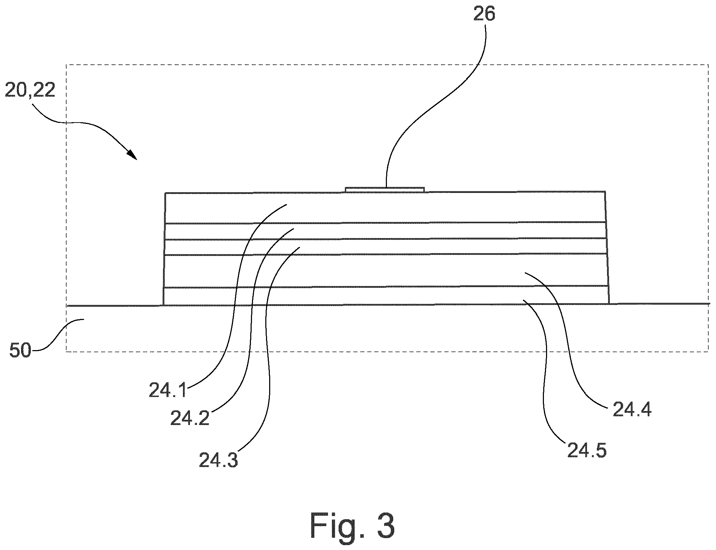

The first measuring system 20 comprises a layer unit 22, several layer elements 24.1, 24.2, 24.3, 24.4, 24.5 and a measuring unit 26. The layer unit 22 is attached to the bus bar 50. A detailed illustration of the first measuring system 20 is shown in Fig. 3.

The number of the shown layer elements 24.1, 24.2, 24.3, 24.4, 24.5 is merely exemplary and can be more or less. In this example, five layer elements 24.1, 24.2, 24.3, 24.4, 24.5 are shown. A top layer element 24.1, an intermediate layer element 24.3 and a bottom layer element 24.5 are electrically conductive in this example and may comprise or be made from copper and/or aluminum, for example. Thus, they are also provided with the capability to transfer heat from the bus bar 50 to the measuring unit 26, which is configured to measure the temperature of the bus bar 50 and generate a first signal indicative of the temperature of the bus bar 50. Further, for example, the bottom layer element 24.5 may be welded or soldered to the bus bar 50.

The further intermediate layer elements 24.2, 24.4 are galvanically isolating in this example and may comprise or be made from a dielectric material, for example. Hence, these prevent the electrical energy from being conducted from the bus bar 50 to the measuring unit 26 and potentially damaging it, while allowing heat to be transferred therethrough for the temperature measurement.

The second measuring system 30 is attached to the bus bar 50 via electrically conductive mounting units 32.1, 32.2 shown herein exemplary as being metallic and cylindrically shaped. The mounting units 32.1, 32.2 attach an electrically conductive carrier unit 34 of the second measuring system 30 to the bus bar 50, e.g., by a screwed, bolted, soldered and/or welded connection. The carrier unit 34 is formed herein as a printed circuit board (PCB). The interface system 40 is at least partially mounted on the carrier unit 34. This means that at least one interface unit of the interface system 40, such as a connector or a modulating unit, is mounted on the carrier unit 34. In this example, an amplifier 42 is mounted on the carrier unit 34 and thereby carried by the carrier unit 34. Tracks of the carrier unit 34 lead from the mounting units 32.1, 32.2 to the interface system 40, in this example the amplifier 42. The tracks may have a substantially equal length and/or the amplifier 42 may be mounted on a center region of the carrier unit 34. Thereby, gain errors and voltage errors at very low currents may be reduced or prevented. The second measuring system 30 thereby provides a second signal indicative of a voltage of the bus bar 50 to the interface system 40. To be more precise, the second signal may be the electrical energy carried by the bus bar 50 and transferred via the second measuring system 30 to the interface system 40 and thus being indicative of the voltage of the electrical energy carried by the bus bar 50.

The interface system 40 may further comprise or be connected to a determination unit 44. In the example of Fig. 2, the determination unit 44 is provided together with the amplifier 42 on the carrier unit 34. However, alternatively, the determination unit 44 may also be provided elsewhere and be connected to the interface system 40, in particular the amplifier 42.

Similarly, the interface system 40 is connected to the first measuring system 20, in particular the measuring unit 26 thereof. Accordingly, the interface system 40 may be receiving both, the first signal and the second signal, and provide the determination unit 44 therewith, which may determine the electrical parameter of the bus bar 50 based thereon. The electrical parameter may be a current and/or voltage, for example, where the voltage may be an adopted or modified voltage as indicated by the second signal. In other words, the voltage as electrical parameter may be the voltage indicated by the second signal and modified based on the temperature of the bus bar 50 indicated by the first signal.

As may be seen from Fig. 2, the apparatus 10 is attached to the bus bar 50 at a first portion 52 having a smaller cross section than two second portions 54 of the bus bar 50, the first portion 52 being located in between the two second portions 54 with the larger cross section. The extension of the bus bar 50 in length may be in a direction along both second portions 54. In other words, the first portion 52 may be an intermediate portion, in particular between second portions 54 with larger cross section, along the length of the bus bar 50. Hence, the bus bar 50 may generally extend with a cross section corresponding to the one shown for the second portions 54, wherein along its lengthy extension the first portion 52 with the smaller cross section may be provided for attachment of the first measuring system 20 and the second measuring system 30 thereto.

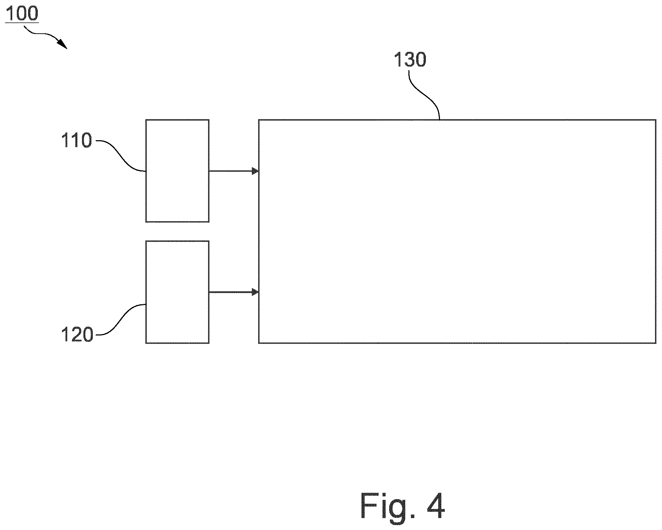

Figure 4 shows an example of a method 100 for determining the electrical parameter of the bus bar 50 by the apparatus 10, when the bus bar 50 is carrying electrical energy. The method 100 may be carried out by the determination unit 44, for example.

In step 110, the first signal is being received. This may be preceded by a temperature measurement by the first measuring system 20.

In step 120, the second signal is being received. This may be preceded by a signal conditioning by the amplifier 42. The signal conditioning may comprise at least one of noise controlling of the second signal and amplifying the second signal.

In step 130, the electrical parameter of the bus bar 50 based on the received first signal and second signal is determined. Determining the electrical parameter may comprise determining an electrical resistance of the bus bar 50 based on the first signal and data indicative of a correlation of a temperature of the bus bar to an electrical resistance of the bus bar. The data may be stored on a storage of the determination unit 44, for example. The determining of the electrical parameter of the bus bar 50 may then be based on the second signal and the determined electrical resistance of the bus bar 50.

As used herein, the phrase "at least one," in reference to a list of one, or more entities should be understood to mean at least one entity selected from any one, or more of the entities in the list of entities, but not necessarily including at least one of each, and every entity specifically listed within the list of entities, and not excluding any combinations of entities in the list of entities. This definition also allows that entities may optionally be present other than the entities specifically identified within the list of entities to which the phrase "at least one" refers, whether related, or unrelated to those entities specifically identified. Thus, as a non-limiting example, "at least one of A and B" (or, equivalently, "at least one of A or B," or, equivalently "at least one of A and/or B") may refer, in one example, to at least one, optionally including more than one, A, with no B present (and optionally including entities other than B); in another example, to at least one, optionally including more than one, B, with no A present (and optionally including entities other than A); in yet another example, to at least one, optionally including more than one, A, and at least one, optionally including more than one, B (and optionally including other entities). In other words, the phrases "at least one," "one, or more," and "and/or" are open-ended expressions that are both conjunctive, and disjunctive in operation. For example, each of the expressions "at least one of A, B, and C," "at least one of A, B, or C," "one, or more of A, B, and C," "one, or more of A, B, or C," and "A, B, and/or C" may mean A alone, B alone, C alone, A and B together, A and C together, B and C together, A, B, and C together, and optionally any of the above in combination with at least one other entity.

Other variations to the disclosed examples may be understood, and effected by those skilled in the art in practicing the claimed subject matter, from the study of the figures, the disclosure, and the appended claims. In particular, respective parts/functions of the respective example described above may also be combined with each other. In the claims, the word "comprising" does not exclude other elements, or steps, and the indefinite article "a" or "an" does not exclude a plurality. The mere fact that certain measures are recited in mutually different dependent claims does not indicate that a combination of these measures may not be used to advantage. Any reference signs in the claims should not be construed as limiting the scope of the claims.

### LIST OF REFERENCES

- 1: vehicle
- 10: apparatus
- 20: first measuring system
- 22: layer unit
- 24: layer element
- 26: measuring unit
- 30: second measuring system
- 32: mounting unit
- 34: carrier unit
- 40: interface system
- 42: amplifier
- 44: determination unit
- 50: bus bar
- 52: first portion
- 54: second portion
- 100: method
- 110, 120, 130: steps

## Claims

1. An apparatus (10) for determining an electrical parameter of a bus bar (50), the apparatus (10) comprising:
a first measuring system (20) for attachment to the bus bar (50), the first measuring system (20) being configured to provide a first signal indicative of a temperature of the bus bar (50);
a second measuring system (30) for attachment to the bus bar (50), the second measuring system (30) being configured to provide a second signal indicative of a voltage of the bus bar (50); and
an interface system (40) configured to provide the first and the second signals to a determination unit (44) for determining the electrical parameter of the bus bar (50) based on the first signal and the second signal.

2. The apparatus (10) according to claim 1, the second measuring system (30) comprising electrically conductive mounting units (32.1, 32.2) and an electrically conductive carrier unit (34) for carrying at least part of the interface system (40), the carrier unit (34) being mountable to the bus bar (50) via the mounting units (32.1, 32.2) to electrically connect the interface system (40) to the bus bar (50).

3. The apparatus (10) according to claim 2, the carrier unit (34) being a printed circuit board.

4. The apparatus (10) according to any of the previous claims, the first measuring system (20) comprising a layer unit (22) for attachment to the bus bar (50), the layer unit (22) comprising at least two layer elements (24.1, 24.2, 24.3, 24.4, 24.5), at least one of a top layer element (24.1) and a bottom layer element (24.5) of the layer elements (24.1, 24.2, 24.3, 24.4, 24.5) being electrically conductive, and the first measuring system (20) comprising a measuring unit (26) thermally connectable to the layer unit (22) for measuring the temperature of the bus bar (50) via the layer elements (24.1, 24.2, 24.3, 24.4, 24.5).

5. The apparatus (10) according to claim 4, at least one of the top layer element (24.1) and the bottom layer element (24.5) comprising at least one of copper and aluminum.

6. The apparatus (10) according to claim 4 or 5, the layer unit (22) comprising three or more layer elements (24.1, 24.2, 24.3, 24.4, 24.5).

7. The apparatus (10) according to any one of claims 4 to 6, at least one intermediate layer element (24.2, 24.4) of the layer elements (24.1, 24.2, 24.3, 24.4, 24.5) arranged between the top layer element (24.1) and the bottom layer element (24.5) being galvanically isolating.

8. The apparatus (10) according to claim 7, the at least one intermediate layer element (24.2, 24.4) comprising a dielectric material.

9. The apparatus (10) according to any one of the previous claims, the interface system (40) comprising an amplifier (42) configured to amplify the second signal.

10. The apparatus (10) according to any one of the preceding claims, the apparatus (10) comprising the determination unit (44), the determination unit (44) comprising data indicative of a correlation of a temperature of the bus bar (50) to an electrical resistance of the bus bar (50), the determination unit (44) being configured to determine an electrical resistance of the bus bar (50) based on the first signal and the data, and the determination unit (44) being configured to determine the electrical parameter of the bus bar (50) based on the second signal and the determined electrical resistance of the bus bar (50).

11. A bus bar system (2) for use in a vehicle (1), the bus bar system (2) comprising a bus bar (50) and an apparatus (10) according to any one of the previous claims, the first measuring system (20) being attached to the bus bar (50) and the interface system (40) being electrically connected to the bus bar (50) via the second measuring system (30).

12. The bus bar system (2) of claim 12, at least one of the first measuring system (20) and the second measuring system (30) being attached to a first portion (52) of the bus bar (50), the first portion (52) having a smaller cross section than a second portion (54) of the bus bar (50).

13. The bus bar system (2) of claim 12 or 13, the attachment of at least one of the first measuring system (20) and the second measuring system (30) to the bus bar (50) comprising a welding connection or soldering connection.

14. A method (100) for determining an electrical parameter of a bus bar (50) by an apparatus (10) according to any one of the preceding claims, the method (100) comprising:
- receiving the first signal;
- receiving the second signal; and
- determining the electrical parameter of the bus bar (50) based on the first signal and the second signal.

15. The method (100) of claim 14, wherein determining the electrical parameter comprises determining an electrical resistance of the bus bar (50) based on the first signal and data indicative of a correlation of a temperature of the bus bar (50) to an electrical resistance of the bus bar (50), and determining the electrical parameter of the bus bar (50) based on the second signal and the determined electrical resistance of the bus bar (50).
